Europäisches Patentamt

European Patent Office

Office européen des brevets

(11) Numéro de publication : **0 363 381 B1**

# FASCICULE DE BREVET EUROPEEN

(45) Date de publication du fascicule du brevet :
**08.07.92 Bulletin 92/28**

(51) Int. Cl.⁵ : **G01R 33/34, G01R 33/36**

(21) Numéro de dépôt : **88904233.9**

(22) Date de dépôt : **03.05.88**

(86) Numéro de dépôt international :
**PCT/FR88/00214**

(87) Numéro de publication internationale :
**WO 88/08971 17.11.88 Gazette 88/25**

(54) **ANTENNE ELECTROMAGNETIQUE ET ANTENNE D'EXCITATION POUR UN APPAREIL DE RESONANCE MAGNETIQUE NUCLEAIRE MUNIE D'UNE TELLE ANTENNE ELECTROMAGNETIQUE.**

(30) Priorité : **07.05.87 FR 8706485**

(43) Date de publication de la demande :
**18.04.90 Bulletin 90/16**

(45) Mention de la délivrance du brevet :
**08.07.92 Bulletin 92/28**

(84) Etats contractants désignés :
**DE GB IT NL**

(56) Documents cités :
**EP-A- 0 145 915**
**EP-A- 0 156 979**
**EP-A- 0 200 078**
**EP-A- 0 209 412**
**EP-A- 0 222 982**
**EP-A- 0 249 298**
**WO-A-84/00214**
**DE-A- 3 140 319**

(73) Titulaire : **GENERAL ELECTRIC CGR S.A.**
**13, Square Max-Hymans**
**F-75015 Paris (FR)**

(72) Inventeur : **MAMETSA, Henri-José**
**6, boulevard des Genêts**
**F-31320 Castanet-Tolosan (FR)**
Inventeur : **JACOB, Hervé**
**17, Chemin Blanquet, Villeneuve Tolosane**
**F-31270 Cugnaux (FR)**

(74) Mandataire : **Ballot, Paul Denis Jacques**
**Cabinet Ballot-Schmit, 7, rue le Sueur**
**F-75116 Paris (FR)**

## Description

La présente invention concerne une antenne électromagnétique et une antenne d'excitation pour un appareil de résonance magnétique nucléaire (RMN) munie d'une telle antenne électromagnétique. Elle trouve son application particulièrement dans le domaine médical où des appareils de RMN sont utilisés à des fins de diagnostic. Elle peut néanmoins être mise en oeuvre dans d'autres domaines dès qu'on cherche à réduire l'influence d'un champ électrique rayonné par, ou reçu par, un circuit rayonnant.

Un appareil d'imagerie par RMN comporte essentiellement des moyens pour soumettre un corps à examiner (celui d'un patient) à un champ magnétique uniforme, constant, et intense $B_0$. Soumis à cette influence, le corps reçoit ensuite d'une antenne d'excitation une excitation électromagnétique radiofréquence pour provoquer la résonance de l'oscillation des moments magnétiques de ses particules. A l'issue de cette excitation, on mesure un signal de résonance émis en retour par le corps, quand les moments magnétiques des particules tendent à se réaligner avec le champ $B_0$. Pour certaines régions du corps (tête par exemple), on utilise des antennes qui sont à la fois émettrices et réceptrices. Ces antennes, schématisées par une boucle rayonnante, créent et captent les champs magnétiques. Du fait de la distribution du potentiel dans le circuit constitué par cette boucle, il se crée un champ électrique qui ne contribue pas à la création de l'image. En effet à l'émission, ce champ électrique affaiblit l'efficacité de l'antenne en provoquant des pertes par courant induit dans le patient : toute l'énergie n'est pas utilisée à l'établissement du champ magnétique haute fréquence. A la réception, la boucle rayonnante prélève dans le signal de résonance une composante de champ électrique qui vient perturber la composante de champ magnétique et que l'on cherche à mesurer seule. On a déjà tenté de résoudre ce problème en diminuant le champ électrique moyen produit ou capté par l'antenne. Dans la pratique on s'arrange pour qu'un point milieu de cette antenne soit maintenu, au moment de la résonance, à un potentiel constant.

Une telle solution est par exemple décrite dans EP-A-0 209 412. Deux extrémités de l'antenne résonnent alors en opposition de phase et créent ou captent des champs électriques en opposition de phase et d'intensité moitié par rapport au champ électrique qui seraient créés ou captés par cette antenne en son milieu si ces deux extrémités étaient, elles, maintenues à des potentiels égaux et constants. Cette solution, tout en apportant une amélioration, n'est pas suffisante pour l'efficacité de l'antenne. Dans une autre solution proposée dans EP-A-0200078 on annule complètement le champ électrique mais on est limité en taille d'antenne, en valeur de fréquene, le fait de relier un écran à la masse, comme c'est le cas dans l'antenne selon ce document, crée des effets néfastes de champs électriques avec le corps du patient flottant électriquement.

L'invention a pour objet de remédier aux inconvénients cités en proposant une antenne d'un type particulier. L'antenne de l'invention est définie par la revendication 1. L'écran de cette antenne comporte deux faces, une face en regard du circuit rayonnant, et une face extérieure. Le rôle de l'écran est de confiner le champ électrique à un espace situé entre le circuit rayonnant et cet écran. Par sa face extérieure l'écran peut rayonner un champ magnétique, tout en empêchant la propagation du champ électrique confiné. La meilleure manière de réaliser l'écran consiste à entourer le circuit rayonnant d'un écran conducteur ouvert. Aux limites de cet écran le courant passe d'une face de l'écran à l'autre.

L'invention concerne donc une antenne électromagnétique comprenant un circuit rayonnant masqué par un écran conducteur ouvert. Elle concerne aussi une antenne électromagnétique comprenant un circuit rayonnant masqué par un écran pour empêcher la transmission du champ électrique sans empêcher la transmission du champ magnétique. Elle concerne aussi enfin une antenne d'excitation pour un appareil d'imagerie par résonance magnétique nucléaire comportant quatre antennes électromagnétiques selon l'invention, reliées à un circuit d'émission-réception, ce circuit d'émission-réception comportant un coupleur à 3 dB relié à un circuit d'accord d'impédance pour jouer un rôle de duplexeur entre les quatre antennes électromagnétiques et le circuit d'émission réception.

L'invention sera mieux comprise à la lecture de la description qui suit, et à l'examen des figures qui l'accompagnent. Celles-ci ne sont données qu'à titre indicatif et nullement limitatif de l'invention. Les figures montrent :

– figures 1a et 1b : des vues respectivement en perspective et en coupe d'une antenne électromagnétique selon l'invention;

– figures 1c et 1d : des variantes de réalisation de l'écran ;

– figure 2 : une boucle d'induction symétrisée pour l'excitation ou la réception d'un signal induit dans l'antenne de l'invention ;

– figure 3 : l'exemple préféré d'application de l'antenne de l'invention dans un appareil d'imagerie par résonance magnétique nucléaire.

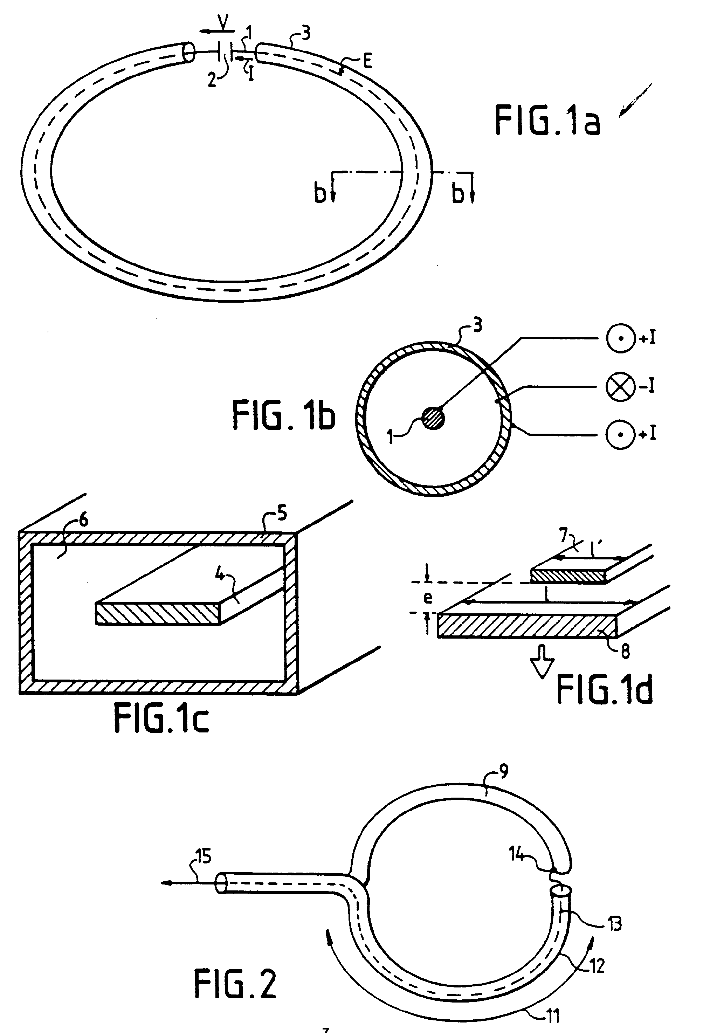

La figure 1 montre une antenne électromagnétique comprenant un circuit rayonnant et un écran. Le cicuit rayonnant présenté dans cette figure comporte un conducteur 1 formé selon une boucle et dont les deux extrémités sont reliées entre elles par un condensateur 2. La self inductance de la boucle 1 associée à la capacité du condensateur 2 permet à ce circuit rayonnant de résonner à une fréquence caractéristique. Le circuit rayonnant est masqué par un écran conducteur ouvert 3. En pratique, le conducteur 1 peut être l'âme d'un câble coaxial dont la tresse 3 sert d'écran pour la propagation d'un champ électrique. Quand le circuit rayonnant est alimenté, il se développe aux bornes du condensateur 2 et une tension (alternative) d'amplitude V. Un courant (alternatif) d'amplitude I parcourt alors le conducteur 1. Du fait d'un effet de peau, Fig. 1b, le courant I circule à la périphérie extérieure du conducteur 1. Le champ magnétique alternatif, au centre de l'écran 3 est nul : un champ magnétique alternatif ne peut pas se développer à l'intérieur d'un conducteur. En conséquence la face interne de l'écran 3 est parcourue par un courant dont l'intensité globale est égale et de sens opposé au sens du courant I. Et de ce fait un champ électrique se développe entre le conducteur 1 et la face interne de l'écran 3. Le courant qui passe à l'intérieur de l'écran conducteur se referme par la face extérieure de cet écran.

Il en résulte que la face extérieure de cet écran est maintenant parcourue par un courant dont l'intensité est égale, et est de même sens que le courant I qui parcoure le conducteur central 1. Les courants circulant sur les surfaces intérieure et extérieure de l'écran ont des axes confondus et des sens de circulation opposés. L'ensemble de ces deux courants ne crée donc pas de répartition de champ magnétique dans leur environnement : la self inductance de l'ensemble surface intérieure - surface extérieure de l'écran est par conséquent très faible, et il ne se développe donc pas de tension aux extrémités de l'écran induit par le courant parcourant ces surfaces. L'écran joue ainsi le rôle de surface équipotentielle nulle sans perturber le champ magnétique induit par le courant circulant dans le conducteur 1. En définitive le courant qui circule à l'extérieur de l'écran 3 n'est qu'un courant induit par le courant qui circule dans le conducteur central du circuit rayonnant. De manière à ce que cette induction soit la plus efficace possible, ce conducteur central et cet écran ont une forme circulaire. De cette manière le courant qui parcourt l'âme 1 induit sans perte le courant inverse qui parcourt la face interne du blindage 3.

Les figures 1c et 1d montrent des variantes de réalisation de l'antenne électromagnétique selon l'invention. En particulier, pour mieux tenir compte de l'effet de peau, on préfère pour le conducteur central 1 une forme plate 4. Dans ces conditions l'écran de blindage 5 a naturellement une section rectangulaire. Le matériau qui sépare l'âme 4 de l'écran 5 doit être un matériau isolant à très faible perte. Ceci signifie que sa constante diélectrique doit être la plus proche possible de 1. La raison en est la suivante : le circuit rayonnant résonne, du fait de la présence du condensateur 2, à une fréquence $f_0$. En fait, la capacité du condensateur 2 s'ajoute à la capacité répartie résultant de la proximité de l'écran 5 et du conducteur central 4. Autant il est connu de fabriquer des condensateurs, à usage localisé, de très bonne qualité (avec de très faibles pertes), autant un soin identique doit être apporté aux matériaux qui séparent l'écran du circuit rayonnant. Le mieux serait de créer le vide, ou éventuellement de remplir cet espace avec de l'air. Cette solution présente cependant un inconvénient sur le plan mécanique : le maintien de l'âme 4 n'est pas assuré. De manière à simplifier la fabrication, on enduit l'âme 4 de matières siliconées et on la recouvre avec l'écran 5. Comme les matières siliconées n'ont pas un très bon comportement diélectrique, on améliore ce comportement en incluant dans le matériau siliconé des microbulles d'air. De préférence le matériau 6 qui remplit l'espace entre l'écran 5 et l'âme 4 est donc une mousse.

Pour simplifier encore plus la fabrication on peut utiliser des circuits imprimés. Selon cette technique le circuit rayonnant est réalisé sur une des faces d'un support. Par exemple une connexion 7 représentant un conducteur rayonnant est bouclée sur elle même en série avec une capacité, tandis que sur l'autre face du support une connexion 8 directement à l'aplomb de la connexion 7 est également gravée. La connexion 8 a, pour mieux assurer son effet d'écran, de préférence une largeur l plus grande que la largeur l' de la connexion 7. La connexion 8 est bien entendu une connexion ouverte, son ouverture peut par exemple se présenter à l'aplomb de l'endroit où est installée dans le circuit rayonnant, la capacité 2. L'épaisseur e et la qualité du matériau dans lequel est réalisé le support de l'antenne de l'invention, sont choisies en fonction des qualités de couplage magnétique à obtenir entre le conducteur 7 et l'écran 8, et en fonction des pertes produites par les capacités réparties résultant de cette mise en vis à vis. La région de l'espace ou le champ rayonné ne comporte pas de composante électrique est indiquée par la flèche creuse. Elle est adossée à la face extérieure de l'écran.

La boucle de la figure 1a, même réalisée sous ses variantes des figures 1c et 1d, doit être alimentée et doit pouvoir restituer le signal qu'elle détecte selon qu'elle est utilisée en excitation ou en détection. De préférence dans l'invention, l'antenne électromagnétique est en relation de couplage avec une boucle d'induction 9 comme celle représentée sur la figure 2. Cette boucle d'induction a la particularité d'être symétrisé. La symétrisation de la boucle d'induction est obtenue en réalisant dans celle-ci un tronçon 11 de ligne haute fréquence (par exemple un tronçon d'un câble coaxial) dont un conducteur intérieur 13 est relié d'une part, 14, au reste de la boucle pour assurer son alimentation, et d'autre part, 15, à un circuit d'émission-réception. De préférence le tronçon 11 a une longueur égale à la moitié de la boucle d'induction de manière à assurer la symétrisation.

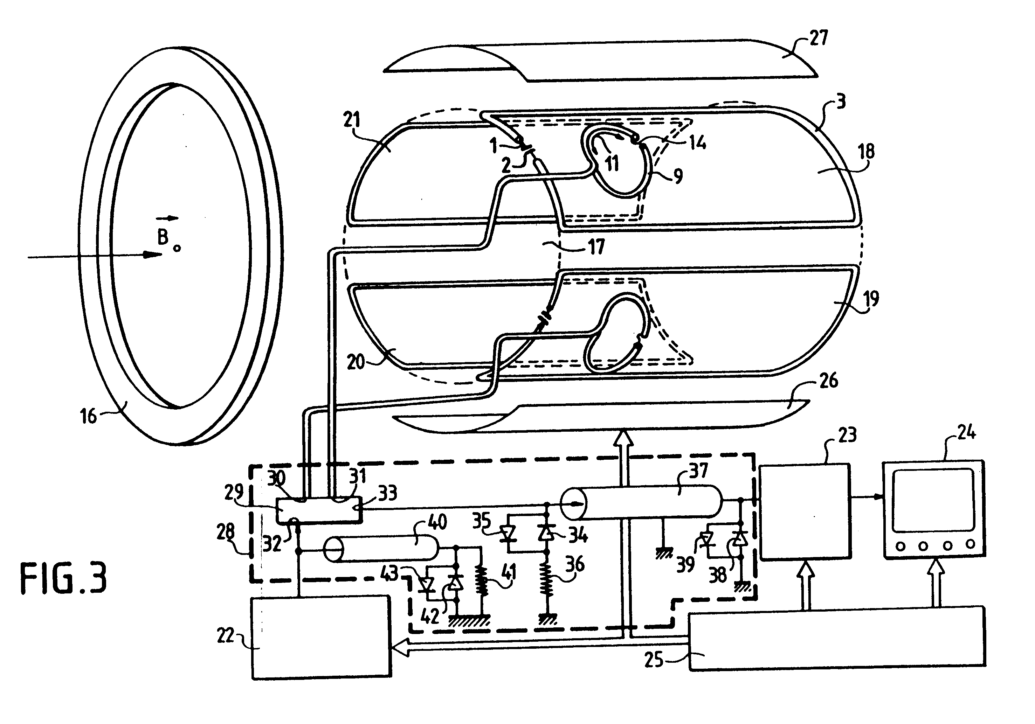

La figure 3 montre un exemple particulier d'utilisation d'une antenne électromagnétique selon l'invention. Dans un appareil d'imagerie par RMN, un aimant symboliquement représenté par la référence 16, produit un champ d'induction orientateur $B_0$ dans une région 17 de l'espace, où il est envisagé de placer un corps à étudier. Dans le domaine médical, le corps d'un patient y est introduit par exemple en position allongée. Soumis à ce champ orientateur, les moments magnétiques des particules du corps tendent à s'aligner avec lui. Avec une antenne d'excitation utilisable aussi bien en émission qu'en réception, et comportant 4 antennes électromagnétiques 18 à 21 selon l'invention, il est possible de faire basculer l'orientation des moments magnétiques hors de leur alignement selon $B_0$ . A l'issue de l'excitation, l'antenne d'excitation peut être utilisée pour mesurer le signal réémis par les particules quand leurs moments magnétiques tendent à se réaligner avec le champ $B_0$. Dans ces conditions l'appareil d'imagerie par RMN comporte un générateur 22 pour appliquer à l'antenne d'excitation les excitations, et un récepteur 23 connecté à l'antenne d'excitation pour recevoir le signal réémis résultant du retour à l'équilibre à l'issue de ces excitations. Le récepteur 23 peut en outre comporter, d'une manière connue, des moyens de traitement du signal reçu pour en extraire des données susceptibles de servir à la représentation, dans un dispositif 24, de coupes du corps étudié. Pour faire fonctionner cet ensemble un séquenceur 25 organise l'intervention du générateur 22, du récepteur 23, du dispositif de visualisation 24 ainsi qu'en outre, de celles de bobines de gradient 26, 27 qui servent à coder le signal émis et reçu de manière à permettre la reconstruction des images des coupes du corps.

Interposé entre l'antenne 18-21 et l'émetteur-récepteur 22-23 est placé un duplexeur 28. Ce duplexeur 28 comporte essentiellement un coupleur à 3dB 29. Deux sorties 30 et 31, en quadrature de phase, de ce coupleur sont chacunes reliées respectivement à un couple d'antennes électromagnétiques selon l'invention, 19 et 21 d'une part, et 18 et 20 d'autre part. Les antennes électromagnétiques de chaque couple sont placées chacune à peu près symétriquement par rapport au corps à examiner. Les couples d'antennes électromagnétiques rayonnent et captent des composantes de champ magnétique sensiblement orthogonales. Les antennes électromagnétiques sont chacune couplée à une boucle d'induction. Les sens de circulation des courants dans chacune des boucles d'induction des couples d'antennes en vis à vis sont inversés de manière à ce que le champ créé au moment de l'excitation soit un champ tournant. De cette manière l'antenne est aussi particulièrement adaptée à la réception d'un champ électromagnétique tournant. On sait en RMN que cette disposition permet de gagner un facteur de trois dB au moment de l'émission et de la réception du signal.

Les deux autres entrées du coupleur 29 sont destinées, la première 32, au générateur 22, et la deuxième 33 au récepteur 23. Sur le plan pratique les antennes électromagnétiques 18 à 21 sont placées sur une structure circulaire, par exemple un mandrin, non représenté. Cette structure présente cependant la particularité que la place des boucles d'induction telles que 9 par rapport au circuit rayonnant de chaque antenne électromagnétique peut être modifiée de manière à effectuer l'adaptation d'impédance correcte de chaque couple d'antenne.

De manière à parfaire l'adaptation d'impédance et à utiliser le coupleur directif dans des conditions optimum, d'autres circuits d'équilibrage sont prévus. En particulier pendant l'émission, si l'antenne d'excitation est désadaptée, une partie du signal émis passe directement par la sortie 33 de réception. Aussi à cette sortie, le signal voit deux impédances en parallèle. Une première impédance est constituée par un ensemble de diodes 34, 35 montées tête bêche en série avec une résistance 36, et une deuxième impédance, rapportée par une ligne 37, d'un autre couple 38,39 de diodes montées tête bêche. La longueur de la ligne 37 est égale à $\lambda/4$. La longueur $\lambda$ représente la longueur d'onde, dans la ligne 37, de l'onde qui s'y propage à la fréquence de résonance de l'appareil. A l'émission le signal est fort, de sorte que les seuils de conduction des diodes 34, 35 et 38, 39 peuvent être considérés comme nuls. En conséquence, la ligne haute fréquence 37, chargée par un court circuit, rapporte à son entrée un circuit ouvert : d'impédance infinie. De plus, la résistance 36 est une résistance de valeur égale à une impédance caractéristique (par exemple 50 Ohms). Il en résulte que la sortie 33 est chargée à l'émission par une charge adaptée. Dans ces conditions, toute l'énergie émise est disponible sur les voies 30 et 31.

A la réception le générateur 22 est hors service et donc la voie 32 est chargée, au travers d'une ligne 40 par une résistance d'impédance caractéristique 41. Comme cette résistance 41 est aussi égale à la résistance caractéristique, la voie 32 est donc chargée par une résistance caractéristique. Pour que ce circuit (40, 41) ne joue cependant pas un rôle néfaste à l'émission, la résistance 41 est en parallèle avec deux diodes 42, 43 montés tête-bêche, et la longueur de la ligne 40 vaut aussi $\lambda/4$. A l'émission, le signal fort court circuite les diodes 43 et 42 et ce court-circuit est rapporté à l'entrée de la ligne 40 sous la forme d'un circuit d'impédance infinie. Pendant la réception, aucune des diodes n'est passante de sorte que le signal reçu sur la voie 33 est conduit directement dans le récepteur 23.

**Revendications**

1. Antenne électromagnétique destinée à exciter une région de l'espace et comprenant un circuit rayonnant (1) masqué presque en totalité vis à vis de cette région au moins un écran (3) conducteur ouvert caractérisée en ce que le circuit rayonnant (1) est accordé pour résonner à une fréquence prédéterminée, par un condensateur (2) placé en série à l'endroit de l'ouverture de l'écran (3).

2. Antenne électromagnétique selon la revendication 1, caractérisée en ce que l'écran (3) est à un potentiel flottant.

3. Antenne selon la revendication 1 ou 2, caractérisé en ce que l'écran (3) comporte une gaine conductrice ouverte.

4. Antenne selon la revendication 3, caractérisée en ce que la gaine est de section sensiblement rectangulaire.

5. Antenne selon la revendication 3, caractérisée en ce que la gaine est séparée du circuit rayonnant par une matière (6) isolante à faible perte diélectrique.

6. Antenne selon l'une quelconque des revendications 1 à 5, caractérisée en ce que le circuit rayonnant comporte une connexion (7) métallique réalisée sur une face d'un support (e), en ce que l'écran (3) comporte une connexion métallique (8) réalisée en vis à vis de la connexion rayonnante sur l'autre face du support, et en ce que la connexion d'écran (3) est sensiblement plus large (1, 1′) que la connexion rayonnante.

7. Antenne selon l'une quelconque des revendications 1 à 6, caractérisée en ce qu'elle est couplée magnétiquement à une boucle d'induction (9).

8. Antenne selon la revendication 7, caractérisée en ce que la boucle d'induction (9) comporte un tronçon (11) de ligne haute fréquence munie d'une âme (13) et d'un conducteur d'écran (12), l'âme (13) de cette ligne étant reliée d'une part au reste de la boucle et d'autre part à un circuit d'émission-réception de l'excitation, et l'écran (12) participant à la boucle (9) pour assurer la symétrisation de cette boucle (9).

9. Antenne d'excitation pour un appareil d'imagerie par résonance magnétique nucléaire, caractérisée en ce qu'elle comporte quatre antennes électromagnétiques (18-21) selon la revendication 8 reliées à un circuit d'émission-réception (22-23), ce circuit d'émission-réception comportant un coupleur (29) à 3 dB relié à un circuit (30-43) d'accord d'impédance pour jouer un rôle de duplexeur entre les quatre antennes électromagnétiques et le circuit d'émission-réception.

## Claims

1. Electromagnetic antenna designed for the excitation of a spatial region and comprising a radiant circuit (1) almost totally masked in relation to the said region by at least one open conductor screen (3), characterized in that the radiant circuit (1) is tuned to resonate at a predetermined frequency, by a compensator (2) mounted in series in the locality of the opening of the screen (3).

2. Electromagnetic antenna according to Claim 1, characterized in that the screen (3) at a floating potential.

3. Antenna according to Claim 1 or 2, characterized in that the screen (3) comprises an open conductor sheath.

4. Antenna according to Claim 3, characterized in that the sheath is of substantially rectangular section.

5. Antenna according to Claim 3, characterized in that the sheath is separated from the radiant circuit by an insulating material (6) of low dielectric loss.

6. Antenna according to any one of Claims 1-5, characterized in that radiant circuit comprises a metallic connection (7) provided on one face of a support (e), that the screen (3) comprises a metal connection (8) provided opposite the radiant connection on the other face of the support and that the connection of the screen (3) is substantially wider (1, 1′) than the radiant connection.

7. Antenna according to any one of Claims 1-6, characterized in that it is magnetically coupled to an induction loop (8).

8. Antenna according to Claim 7, characterized in that the induction loop (9) includes a high frequency line section (11) provided with a core (13) and with a screen conductor (12), the core (13) of the said line being connected on the one hand to the remainder of the loop and on the other hand to an excitation emitting and receiving circuit, the screen (12) participating in the loop (9) in order to render the said loop (9) symmetrical.

9. Excitation antenna for a nuclear magnetic resonance imaging apparatus, characterized in that it comprises four electro-magnetic antennas (18-21), according to Claim 8, connected to an emitting and receiving circuit (22-23), this emitting and receiving circuit comprising a coupling device (29) of 3 dB connected to an impedance tuning circuit (30-43) in order to function as a duplexing device between the four electro-magnetic antennas and the emitting and receiving circuit.

## Patentansprüche

1. Elektromagnetische Antenne zur Erregung eines Raumbereiches mit einer ausstrahlenden, relativ zu diesem Bereich durch mindestens eine leitende offene Abschirmung beinahe völlig maskierten (3) austrahlende Schaltung (1), dadurch gekennzeichnet, daß die ausstrahlende Schaltung durch einen in Reihe mit dem Ort der Öffnung der Abschirmung (1) angeordneten Kondensator (2) auf eine vorbestimmte Resonanzfrequenz gestimmt ist.

2. Antenne nach Anspruch 1, dadurch gekennzeichnet, daß die Abschirmung (3) auf einem Schwebepotential gehalten wird.

3. Antenne nach Anspruch 1 oder nach Anspruch 2, dadurch gekennzeichnet, daß die Abschirmung (3) eine offene leitende Hülle umfaßt.

4. Antenne nach Anspruch 3, dadurch gekennzeichnet, daß die Hülle einen im wesentlichen rechteckigen Querschnitt aufweist.

5. Antenne nach Anspruch 3, dadurch gekennzeichnet, daß die Hülle von der ausstrahlenden Schaltung durch ein isolierndes, einen geringen dielektrischen Verlust aufweisendes Material (6) abgetrennt ist.

6. Antenne nach einem der vorhergehenden Ansprüche 1 bis 5, dadurch gekennzeichnet, daß die ausstrahlende Schaltung eine an einer Oberfläche einer Unterlage (e) vorgesehene metallische Verbindung (7) besitzt, daß die Abschirmung (3) eine metallische gegenüber der ausstrahlenden Verbindung auf der anderen Seite der Unterlage vorgesehen Verbindung (8) besitzt, und daß die Verbindung der Abschirmung (3) wesentlich breiter (1 und 1′) als die ausstrahlende Verbindung ist.

7. Antenne nach Anspruch 1 bis 6, dadurch gekennzeichnet, daß sie mit einer Induktionsschleife (9) magnetisch gekoppelt ist.

8. Antenne nach Anspruch 7, dadurch gekennzeichnet, daß die Induktionsschleife (9) einen mit einer Ader (13) und mit einem Schirmleiter (12) versehenen Hochfrequenzast (11) umfaßt, wobei die Ader (13) dieses Leiters einerseits mit dem übrigen Teil der Schleife und andererseits mit einer Sendeempfangschaltung zur Erregung verbunden ist, und wobei die Abschirmung (12) mit der Schleife (9) zusammenarbeitet, um die Symmetrie der Schleife (9) zu gewährleisten.

9. Erregungsantenne für einen bildgebenden Kernspinresonanz-Apparat, dadurch gekennzeichnet, daß sie vier elektromagnetische Antennen (18 bis 21) nach Anspruch 8 umfaßt, die mit einer Sendeempfangschaltung (22 und 23) verbunden sind, wobei diese Sendeempfangschaltung einen mit einer Schaltung (30 bis 43) zur Impedanzabstimmung verbundenen 3-dB-Koppler (29) umfaßt, um die Rolle eines Sendeempfangsschalters zwischen den vier elektromagnetischen Antennen und der Sendeempfangschaltung zu übernehmen.

FIG.1a

FIG.1b

FIG.1c

FIG.1d

FIG.2

FIG.3

$\vec{B}_o$

EP 0 363 381 B1